Europäisches Patentamt

**European Patent Office**

Office européen des brevets

(11) Numéro de publication: **0 061 374**
**B1**

## (12) FASCICULE DE BREVET EUROPEEN

(45) Date de publication du fascicule du brevet:
31.07.85

(21) Numéro de dépôt: **82400382.6**

(22) Date de dépôt: **05.03.82**

(51) Int. Cl.⁴: **H 01 L 41/18**

(54) Procédé de fabrication d'un matériau composite piézoélectrique.

(30) Priorité: **13.03.81 FR 8105058**

(43) Date de publication de la demande:
**29.09.82 Bulletin 82/39**

(45) Mention de la délivrance du brevet:
**31.07.85 Bulletin 85/31**

(84) Etats contractants désignés:
**DE FR GB IT**

(56) Documents cités:
**DE - A - 2 922 260**
**DE - C - 476 506**
**DE - C - 564 885**

(73) Titulaire: **COMMISSARIAT A L'ENERGIE ATOMIQUE
Etablissement de Caractère Scientifique Technique et
Industriel, 31/33, rue de la Fédération, F-75015 Paris (FR)**

(72) Inventeur: **Peuzin, Jean Claude, Lotissement
des 4 Seigneurs 7 Herbeys, F-38320 Eybens (FR)**

(74) Mandataire: **Mongrédien, André et al, c/o
BREVATOME 25, rue de Ponthieu, F-75008 Paris (FR)**

Description

La présente invention concerne un procédé de fabrication d'un matériau composite piézoélectrique à partir de grains pyroélectriques. Elle s'applique en particulier dans le domaine des ultrasons notamment utilisés pour le nettoyage de surface, le contrôle des soudures, et l'échométrie médicale et dans le domaine de l'allumage par étincelle.

Actuellement, les matériaux piézoélectriques connus sont les céramiques ferroélectriques telles que les céramiques du type zirconate-titanate de plomb connu sous l'abréviation de PZT, et les matériaux composites ferroélectriques ou pyroélectriques et les polymères ferroélectriques.

Les céramiques ferroélectriques sont constituées de grains ou cristallites ferroélectriques, présentant une polarisation spontanée, liés entre eux par frittage à haute température. Aucun matériau de liaison n'est nécessaire, sauf éventuellement, en très petite quantité. L'orientation des cristallites est rendue possible, après coup, en appliquant un champ électrique sur la céramique, après l'élaboration de celle-ci, provoquant le basculement de la polarisation spontanée de chaque cristallite vers la direction la plus voisine de celle du champ électrique appliqué. Dans cette orientation des cristallites, il n'y a pas de rotation du grain ferroélectrique mais seulement orientation d'un degré de liberté interne du motif cristallin, constituant la structure microscopique des céramiques.

Les matériaux composites piézoélectriques sont constitués de grains ou cristallites noyés dans un liant organique.

Lorsque ces cristallites sont ferroélectriques, leur orientation procède de la même méthode que pour les céramiques ferroélectriques, c'est-à-dire par action d'un champ électrique sur la polarisation spontanée des grains ferroélectriques, après élaboration des matériaux avec, en plus, l'inconvénient causé par la présence du liant qui contribue à diminuer le champ effectif agissant sur les grains ferroélectriques.

Par ailleurs, ces matériaux composites, formés de grains ferroélectriques, présentent, comme pour les céramiques ferroélectriques, un inconvénient important lié à leur nature ferroélectrique. En effet, ils se dépolarisent facilement sous l'action de contraintes extérieures diverses telles qu'une température élevée, des champs électriques parasites, des contraintes mécaniques.

En particulier, cet inconvénient qui se traduit par une perte des propriétés piézoélectriques est notable dans les applications suivantes:

— générateur haute tension par exemple pour l'allumage par étincelle,
— générateur d'ultrasons de puissance par exemple pour le nettoyage de surfaces et les sonars.

Pour les mêmes raisons, le phénomène de dépolarisation spontanée de ces matériaux se traduit par un vieillissement prématuré des caractéristiques physiques desdits matériaux.

Lorsque les cristallites des matériaux composites sont pyroélectriques, l'élaboration des matériaux composites se fait en utilisant des cristallites finement divisées, c'est-à-dire présentant la forme d'une poudre, en les plaçant dans un liquide tel que de la paraffine, en soumettant lesdites cristallites à l'action d'un champ électrique de manière à les orienter de façon analogue, puis en solidifiant l'ensemble. Une telle élaboration de matériaux composites est décrite dans le brevet allemand n° 564 885.

Malheureusement, ce procédé d'élaboration n'est applicable que dans très peu de cas. En effet, le mécanisme d'orientation des grains pyroélectriques repose sur l'existence d'un moment dipolaire électrique $\vec{\mu}$, associé à chaque grain, sur lequel l'application d'un champ électrique $\vec{E}$ donne naissance à un couple d'orientation C tel que $C = \vec{\mu} \wedge \vec{E}$.

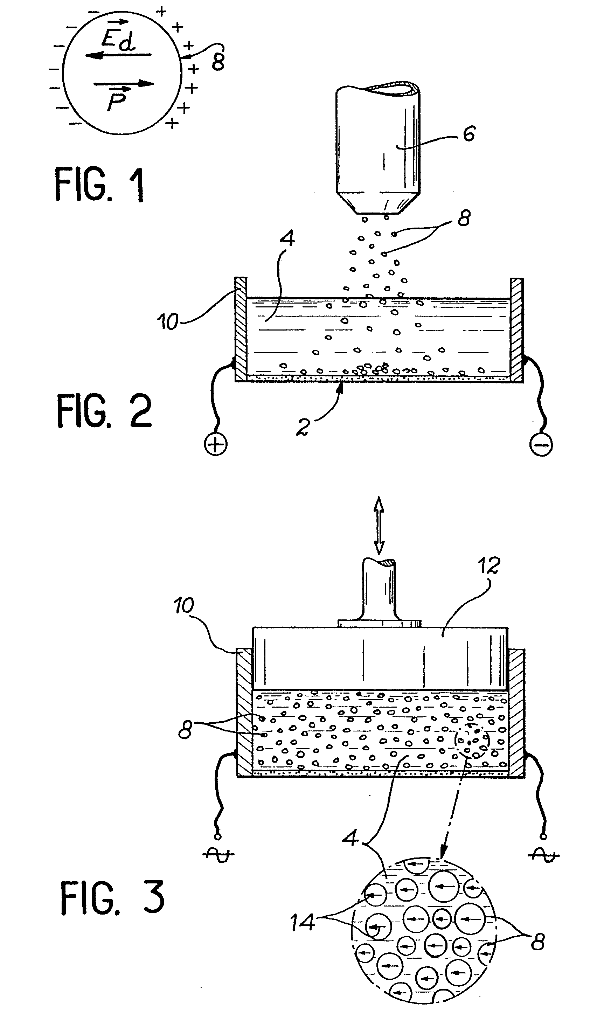

Or, l'existence permanente ou quasi permanente d'un tel moment dipolaire n'est en fait possible que dans le cas où les grains pyroélectriques sont très isolants. En effet, l'existence d'un moment dipolaire $\vec{p}$, dans un grain pyroélectrique 8 par exemple sphérique, entraîne automatiquement comme représenté sur la figure 1, un champ électrique dépolarisant $\vec{E}_d$. Pour un grain pyroélectrique de résistivité finie $\rho$, le champ $\vec{E}_d$ entraîne la circulation d'un courant dont l'effet est d'accumuler sur la surface du grain 8 des charges positives (+) et des charges négatives (−) tendant à compenser le moment dipolaire résultant initial de valeur $\mu_0$. On montre facilement que la valeur du moment dipolaire résultant $\mu$ diminue au cours du temps (t) suivant la loi $\mu(t) = \mu_0 \exp{-t/\tau}$ dans laquelle $\mu_0$ est la valeur initiale du moment dipolaire résultant et $\tau$ une constante de temps définie par l'équation $\tau = \varepsilon\varepsilon_0\rho$ dans laquelle $\rho$ est la résistivité du grain et $\varepsilon\varepsilon_0$ la permittivité diélectrique du grain. Dans la plupart des grains pyroélectriques, la constante de temps $\tau$ excède rarement quelques secondes. En conséquence, l'existence d'un moment dipolaire résultant permanent est donc exclue pour la plupart des grains pyroélectriques.

Certains polymères tels que le difluorure de polyvinyle connu sous l'abréviation de PVdF peuvent se préparer sous forme de couches minces montrant des propriétés piézoélectriques. Le traitement consiste à étirer la feuille de polymère et à la soumettre à un champ électrique. Ces matériaux qui ne peuvent donc pas être élaborés sous forme d'échantillons massifs, ne peuvent pas être utilisés dans de nombreuses applications et essentiellement dans le domaine des ultrasons à basse fréquence.

La présente invention a justement pour objet un procédé de fabrication d'un matériau composite piézoélectrique, à partir de grains pyroélectriques, permettant de remédier à ces différents inconvénients.

Contrairement à la fabrication des matériaux à grains ou cristallites ferroélectriques de l'art antérieur, l'orientation des grains se fait au cours de l'élaboration desdits matériaux et non après l'élaboration de ceux-ci. De plus, par rapport au document allemand cité précédemment, le procédé selon l'invention permet la création d'un moment dipolaire transitoire, ce qui permet d'utiliser ce procédé de fabrication avec tout type de grains pyroélectriques, non ferroélectriques.

De façon plus précise, l'invention a pour objet un procédé de fabrication d'un matériau composite piézoélectrique à partir de grains pyroélectriques selon lequel:

— on dispose des grains pyroélectriques présentant un moment dipolaire résultant nul, dans un matériau liquide,
— on applique à la suspension liquide obtenue un champ électrique, et
— on solidifie la suspension obtenue,

ce procédé étant caractérisé en ce que, avant la solidification, on crée un moment dipolaire transitoire sur chaque grain pyroélectrique de façon à orienter lesdits moments dipolaires transitoires selon une direction unique, ces grains étant non ferroélectriques.

Un tel procédé de fabrication peut être appliqué à tous les grains pyroélectriques connus, non ferroélectriques ce qui lui confère un caractère universel.

L'utilisation de grains pyroélectriques, non ferroélectriques, permet d'obtenir des matériaux composites ne possèdant pas les inconvénients mentionnés plus haut, et en particulier, ils sont insensibles aux effets de dépolarisation puisqu'ils ne présentent pas de domaines ferroélectriques.

Par ailleurs, ces matériaux peuvent être fabriqués facilement sous forme d'échantillons massifs.

Dans ce procédé de fabrication on peut créer le moment dipolaire transitoire des grains pyroélectriques, par exemple au moyen d'une brusque variation de température apparaissant lorsque lesdits grains, tombant dans le matériau proté à une température supérieure à la température ambiante, prennent contact avec ledit matériau, ou en appliquant au matériau contenant lesdits grains, une variation rapide de la pression hydrostatique.

Dans le cas où la création du moment dipolaire transitoire se fait par variation rapide de la pression, ladite variation de pression peut être variable selon les points du matériau de façon que l'orientation des grains soit variable selon ces points.

De préférence, le matériau utilisé est un matériau isolant tel qu'une résine polymérisable.

D'autres caractéristiques et avantages de l'invention ressortiront mieux de la description qui va suivre, donnée à titre explicatif et nullement limitatif, en référence aux figures annexées, sur lesquelles:

— la figure 1, déjà décrite, est une vue schématique représentant un grain pyroélectrique,
— la figure 2 représente schématiquement, selon un premier mode de réalisation, le procédé de fabrication d'un matériau composite piézoélectrique selon l'invention, et
— la figure 3 représente schématiquement, selon un deuxième mode de réalisation, le procédé de fabrication d'un matériau composite piézoélectrique selon l'invention.

Selon l'invention, les matériaux composites piézoélectriques sont constitués de grains ou cristallites pyroélectriques, non ferroélectriques, c'est-à-dire à symétrie polaire, noyés dans une matrice par exemple isolante, réalisée par exemple en matière plastique, et dont tous les axes polaires sont orientés parallèlement à une direction donnée. De tels matériaux composites présentent une symétrie macroscopique qui est aussi polaire. Ces matériaux composites sont donc pyroélectriques et par conséquent piézoélectriques.

Comme matière plastique entrant dans la constitution de ces matériaux composites on peut utiliser des résines au silicone, des résines époxydes comme par exemple des résines commercialisées sous la marque Araldite, des phénoplastes, des polyuréthanes, des polyesters insaturés polymérisés avec du styrène.

Comme grains piézoélectriques, entrant dans la constitution de ces matériaux composites, on peut utiliser des grains pyroélectriques, non ferroélectriques, tels que des grains de sulfure ou d'oxyde de zinc, des grains de sulfure de cadmium, des grains d'oxyde de tellure.

Sur la figure 2, on a représenté, selon un premier mode de réalisation, un procédé de fabrication d'un matériau composite piézoélectrique tel que décrit précédemment.

Dans un récipient 2 contenant un matériau par exemple isolant 4 sous forme liquide, on fait tomber au moyen d'un distributeur 6 des grains ou cristallites pyroélectriques 8, présentant un moment dipolaire résultant nul. Ces grains sont non ferrélectriques. Au moyen d'électrodes 10 situées sur deux côtés opposés du récipient 2, on applique au matériau isolant ou plus exactement à la suspension obtenue un champ électrique, par exemple continu. Le matériau isolant 4 étant porté à une température supérieure à la température ambiante et par exemple inférieure à 100°C pour l'Araldite, les grains pyroélectriques prenant contact avec le matériau isolant chaud voient leur température, s'élever brusquement, entraînant la création d'un moment dipolaire transitoire sur chacun d'eux selon leur axe polaire. La création de ce moment dipolaire transitoire résulte du fait que le moment dipolaire $\vec{p}$ (figure 1) varie avec la température.

Le champ électrique appliqué à la suspension permet d'orienter tous ces moments dipolaires transitoires parallèlement à une direction unique. Après un remplissage suffisant du bain, on solidifie la suspension par exemple en maintenant le champ électrique.

Comme matériaux isolants on peut utiliser des résines polymérisables et notamment thermodurcissables. On peut utiliser par exemple des résines époxydes telles que l'Araldite durcissant entre 130 et 200°C au moyen d'un durcisseur mis au préalable dans le bain.

Il est à noter que le durcissement de la résine au moyen d'un durcisseur est une réaction généralement lente dépendant de la quantité de durcisseur mise dans le bain, de la température du bain et de la nature même de la résine. De plus, le durcissement de certaines résines (polyesters plus styrène par exemple) étant exothermique il n'est pas toujours nécessaire de chauffer le bain.

Selon une variante de ce mode de réalisation, la température du bain, donc la température des grains pyroélectriques peut varier alternativement. Ceci peut par exemple être obtenu en plaçant le récipient 2 dans un four dont on peut faire varier la température alternativement. Dans cette variante, le champ électrique appliqué à la suspension doit être aussi alternatif et en phase avec la variation de la température.

Sur la figure 3, on a représenté, selon un deuxième mode de réalisation, un procédé de fabrication d'un matériau composite piézoélectrique tel que décrit précédemment. Dans cette variante, le matériau liquide par exemple isolant 4 contenant les grains ou cristallites pyroélectriques 8 est soumis à un champ électrique par exemple alternatif. Le moment dipolaire transitoire selon l'axe polaire des cristallites est créé en appliquant au matériau par exemple isolant, liquide, au moyen d'un piston isolant 12 une pression hydrostatique variable. Comme précédemment, la création de ce moment dipolaire transitoire résulte du fait que le moment dipolaire $\vec{p}$ (figure 1) varie avec la pression hydrostatique du bain.

Pour s'affranchir des mauvais isolements du matériau isolant la variation de la pression hydrostatique pourra suivre une loi alternative, à fréquence aussi élevée que nécessaire, loi qui sera en phase avec le champ électrique appliqué si celui-ci est alternatif.

Sur cette figure, on a aussi représenté des cristallites pyroélectriques 8 dont les moments dipolaires 14 suivant leur axe polaire sont tous orientés parallèlement à une direction unique, direction imposée par le champ électrique.

Il est à noter que l'application d'une pression distribuée suivant une certaine loi, associée à un champ électrique continu, permet de créer dans le matériau composite piézoélectrique une répartition d'orientation des moments dipolaires suivant ladite loi. Ceci permet en particulier de faire de l'enregistrement d'hologramme acoustique.

Par ailleurs, on peut, dans ce mode de réalisation, utiliser un champ électrique continu. Dans ce cas, on appliquera une seule variation brusque de la pression.

Le procédé de fabrication selon l'invention, grâce à la création d'un moment dipolaire transitoire, peut être appliqué à tout type de grains pyroélectriques, non ferroélectriques. Lex matériaux composites obtenus selon ce procédé seront avantageusement utilisés pour l'allumage par étincelle.

On va maintenant donner un exemple de réalisation du procédé de fabrication selon l'invention.

Un récipient en téflon®, comportant deux électrodes en cuivre, est rempli d'un bain contenant de l'Araldite liquide et un durcisseur.

Ce bain est porté à une température de 90°C. Sur les électrodes en cuivre, on applique un champ électrique continu de 3 kV/cm. Dans ce bain liquide chaud, on fait tomber des grains présentant un diamètre de 0,8 mm. Il est à noter que la dimension des grains n'est pas critique. La durée totale du remplissage est de 1 min. Après remplissage, l'ensemble est refroidi.

**Revendications**

1. Procédé de fabrication d'un matériau composite piézoélectrique, à partir de grains pyroélectriques selon lequel:

— on dispose des grains pyroélectriques (8), présentant un moment dipolaire résultant nul, dans un matériau liquide (4),
— on applique à la suspension liquide obtenue un champ électrique, et
— on solidifie la suspension obtenue,

ce procédé étant caractérisé en ce que, avant la solidification, on crée un moment dipolaire transitoire sur chaque grain pyroélectrique de façon à orienter lesdits moments dipolaires transitoires selon une direction unique, ces grains étant non ferroélectriques.

2. Procédé de fabrication selon la revendication 1, caractérisé en ce que l'on crée le moment dipolaire transitoire des grains pyroélectriques (8) au moyen d'une brusque variation de température apparaissant lorsque lesdits grains, tombant dans le matériau (4) porté à une température supérieure à la température ambiante, prennent contact avec ledit matériau.

3. Procédé de fabrication selon la revendication 1, caractérisé en ce que l'on crée le moment dipolaire transitoire des grains pyroélectriques (8) en appliquant au matériau (4), contenant lesdits grains, une variation rapide de la pression hydrostatique.

4. Procédé de fabrication selon l'une quelconque des revendications 1 à 3, caractérisé en ce que le champ électrique appliqué au matériau est continu.

5. Procédé de fabrication selon la revendication 2, caractérisé en ce que la variation de la température et le champ électrique sont alternatifs et en phase.

6. Procédé de fabrication selon la revendication 3, caractérisé en ce que la pression et le champ électrique appliqués au matériau (4) sont alternatifs et en phase.

7. Procédé de fabrication selon la revendication 3, caractérisé en ce que ladite variation de pression est variable selon les points du matériau (4) de façon à ce que l'orientation des grains soit variable selon ces points.

8. Procédé de fabrication selon l'une quelconque des revendications 1 à 7, caractérisé en ce que le matériau (4) est isolant.

9. Procédé de fabrication selon la revendication 8, caractérisé en ce que le matériau isolant est une résine polymérisable.

10. Procédé de fabrication selon la revendication 9, caractérisé en ce que la résine polymérisable est une résine thermodurcissable.

11. Procédé de fabrication selon la revendication 10, caractérisé en ce que la résine est une résine époxyde.

## Patentansprüche

1. Verfahren zur Herstellung eines piezoelektrischen Verbundmaterials, bei dem von pyroelektrischen Körnern ausgegangen wird, die pyroelektrischen Körner, die ein sich zu Null ergebendes Dipolmoment aufweisen, in eine Flüssigkeit (4) gegeben werden, an die erhaltene flüssige Suspension ein elektrisches Feld angelegt und die erhaltene Suspension verfestigt wird, dadurch gekennzeichnet, daß vor der Verfestigung an jedem pyroelektrischem Korn ein momentanes Dipolmoment erzeugt wird, um die momentanen Dipolmomente längs einer einzigen Richtung auszurichten, und daß diese Körner nicht ferroelektrisch sind.

2. Herstellungsverfahren nach Anspruch 1, dadurch gekennzeichnet, daß man das momentane Dipolmoment der pyroelektrischen Körner (8) mittels einer plötzlichen Temperaturänderung erzeugt, welche auftritt, wenn die in die Flüssigkeit (4), die auf eine höhere Temperatur als die Umgebungstemperatur gebracht worden ist, fallenden Körner in Berührung mit der Flüssigkeit gelangen.

3. Herstellungsverfahren nach Anspruch 1, dadurch gekennzeichnet, daß das momentane Dipolmoment der pyroelektrischen Körner (8) dadurch erzeugt wird, daß an der Flüssigkeit (4), welche die Körner enthält, eine schnelle Änderung des hydrostatischen Druckes vorgenommen wird.

4. Herstellungsverfahren nach einem der Ansprüche 1 bis 3, dadurch gekennzeichnet, daß das an die Flüssigkeit gelegte elektrische Feld kontinuierlich ist.

5. Herstellungsverfahren nach Anspruch 2, dadurch gekennzeichnet, daß die Temperaturänderung und das elektrische Feld wechselnd und in Phase sind.

6. Herstellungsverfahren nach Anspruch 3, dadurch gekennzeichnet, daß der Druck und das elektrische Feld, die auf die Flüssigkeit (4) angewandt werden, wechselnd und in Phase sind.

7. Herstellungsverfahren nach Anspruch 3, dadurch gekennzeichnet, daß die Druckänderung längs der Stellen der Flüssigkeit (4) derart verändert wird, daß die Ausrichtung der Körner längs dieser Stellen verändert wird.

8. Herstellungsverfahren nach einem der Ansprüche 1 bis 7, dadurch gekennzeichnet, daß die Flüssigkeit (4) isolierend ist.

9. Herstellungsverfahren nach Anspruch 8, dadurch gekennzeichnet, daß die isolierende Flüssigkeit ein polymerisierbarer Kunststoff ist.

10. Herstellungsverfahren nach Anspruch 9, dadurch gekennzeichnet, daß der polymerisierte Kunststoff ein wärmehärtbarer Kunststoff ist.

11. Herstellungsverfahren nach Anspruch 10, dadurch gekennzeichnet, daß der Kunststoff ein Epoxydharz ist.

## Claims

1. Process for the production of a piezoelectric composite material from pyroelectric grains according to which:

— pyroelectric grains (8) having a zero resultant dipole moment, are placed in a liquid material (4),
— an electric field is applied to the thus-obtained liquid suspension, and
— the suspension obtained is solidified,

said process being characterized in that, before solidification, a transistory dipole moment is produced on each pyroelectric grain to orient said transitory dipole moments in a single direction, the grains being non-ferroelectric.

2. Production process according to Claim 1, characterized in that the transitory dipole moment of the pyroelectric grains (8) is produced by means of a rapid variation in temperature amongst said grains in the material (4) brought to a temperature above ambient temperature, and contacting said material.

3. Production process according to Claim 1, characterized in that the transitory dipole moment of the pyroelectric grain (8) is produced by a rapid variation of hydrostatic pressure in the material (4).

4. Production process according to any one of Claims 1 to 3, characterized in that the electric field applied to the material is a continuous field.

5. Production process according to Claim 2, characterized in that the variations in temperature and the electric field are alternating and in phase.

6. Production process according to Claim 3, characterized in that the pressure and the electric field applied to the material (4) are alternating and in phase.

7. Production process according to Claim 3, characterized fin that said pressure variation varies from point to point of the material (4) such that the orientations of the grains also vary at these points.

8. Production process according to any one of Claims 1 to 7, characterized in that material (4) is an insulating material.

9. Production process according to Claim 8, characterized in that the insulating material is a polymerizable resin.

10. Production process according to Claim 9, characterized in that the polymerizable resin is a thermosetting resin.

11. Production process according to Claim 10, characterized in that the resin is an epoxy resin.

FIG. 1

FIG. 2

FIG. 3